# EUROPÄISCHE PATENTANMELDUNG

(11) **EP 4 759 788 A1**
(43) Veröffentlichungstag der Anmeldung: **17.06.2026**
(21) Anmeldenummer: 24219272.2
(22) Anmeldetag: 12.12.2024
(51) Int. Cl.: C04B 37/02

(54) **KUPFER-KERAMIK-SUBSTRAT MIT SINTERBARER OBERFLÄCHE**

(71) Anmelder: Heraeus Electronics GmbH & Co. KG, 63450 Hanau (DE)
(72) Erfinder: Stegmann, Tamira, 63450 Hanau (DE); Gunst, Stefan, 63450 Hanau (DE); Schwöbel, Andre, 63450 Hanau (DE); Bruder, Enrico, 64287 Darmstadt (DE); Durst, Karsten, 64287 Darmstadt (DE)
(74) Vertreter: Heraeus IP

(57) **Zusammenfassung**

Die Erfindung betrifft ein Kupfer-Keramik-Substrat, die Verwendung eines Kupfer-Keramik-Substrats und ein Verfahren zur Herstellung einer festen Verbindung zwischen einem Kupfer-Keramik-Substrat und einem Elektronikbauteil. Das Kupfer-Keramik-Substrat umfasst: a) einen Keramikkörper und b) eine Kupferschicht, die mit dem Keramikkörper flächig verbunden ist. Die Kupferschicht weist eine Oberseite auf, wobei wenigstens 20 % der Kupferkörner eine <101>-Orientierung in Normalrichtung aufweisen. Die Orientierung der Kupferkörner wird in einer Aufnahme der Oberseite der Kupferschicht mittels Elektronenrückstreubeugung (Electron Backscatter Diffraction, EBSD) bestimmt.

## Beschreibung

Die vorliegende Erfindung betrifft ein Kupfer-Keramik-Substrat, die Verwendung eines Kupfer-Keramik-Substrats und ein Verfahren zur Herstellung einer festen Verbindung zwischen einem Kupfer-Keramik-Substrat und einem Elektronikbauteil.

Kupfer-Keramik-Substrate spielen eine wichtige Rolle im Bereich der Leistungselektronik. Sie sind ein maßgebliches Element beim Aufbau von elektronischen Baugruppen und sorgen für eine schnelle Ableitung hoher Wärmemengen beim Betrieb dieser Baugruppen. Kupfer-Keramik-Substrate bestehen üblicherweise aus einer Keramikschicht und einer Kupferschicht, die mit der Keramikschicht verbunden ist.

Zur Verbindung der Kupferschicht mit der Keramikschicht sind aus dem Stand der Technik mehrere Verfahren bekannt. Beim sogenannten DCB ("Direct Copper Bonding") -Verfahren wird eine Kupferfolie durch Reaktion von Kupfer mit einem Reaktivgas (üblicherweise Sauerstoff) oberflächlich mit einer Kupferverbindung (üblicherweise Kupferoxid) versehen, die einen niedrigeren Schmelzpunkt als Kupfer aufweist. Wenn die so behandelte Kupferfolie auf einen Keramikkörper aufgebracht und der Verbund erhitzt wird, schmilzt die Kupferverbindung und benetzt die Oberfläche des Keramikkörpers, so dass es zu einer stabilen stoffschlüssigen Verbindung zwischen der Kupferfolie und dem Keramikkörper kommt. Dieses Verfahren ist zum Beispiel in der US 3744120 A oder der DE 2319854 C2 beschrieben.

In einem alternativen Verfahren können Kupferfolien bei Temperaturen von etwa 650 bis 1000°C mit Keramikkörpern verbunden werden, wobei ein Aktivlot verwendet wird, das ein Metall mit einem Schmelzpunkt von wenigstens 700°C (üblicherweise Silber) und ein Aktivmetall enthält. Die Rolle des Aktivmetalls besteht darin, mit dem Keramikmaterial zu reagieren und so eine Verbindung des Keramikmaterials mit dem übrigen Lot unter Bildung einer Reaktionsschicht zu ermöglichen, während das Metall mit einem Schmelzpunkt von wenigstens 700°C zur Verbindung dieser Reaktionsschicht mit der Kupferfolie dient. So schlägt zum Beispiel die JP4812985 B2 vor, eine Kupferfolie mit einem Keramikkörper unter Verwendung eines Lotes zu verbinden, das 50 bis 89 Gewichtsprozent Silber sowie darüber hinaus Kupfer, Bismut und ein Aktivmetall enthält. Mit diesem Verfahren gelingt es, die Kupferfolie mit dem Keramikkörper fest zu verbinden. Alternativ dazu können auch silberfreie Aktivlote zur Verbindung von Kupferfolien mit Keramikkörpern zum Einsatz kommen. Diese Lote basieren zum Beispiel auf hochschmelzenden Metallen (insbesondere Kupfer), niedrigschmelzenden Metallen (wie Bismut, Indium oder Zinn) und Aktivmetallen (wie Titan). Eine solche Technik wird zum Beispiel in der DE 102017114893 A1 vorgeschlagen. Diese Technik führt im Grunde zu einer neuen, eigenständigen Verbindungsklasse, da die Basis der verwendeten Lote durch ein anderes Metall (Kupfer statt Silber) gebildet wird, was zu geänderten Materialeigenschaften führt und eine Anpassung im Hinblick auf die übrigen Lotbestandteile und modifizierte Fügebedingungen zur Folge hat.

Beim Aufbau von elektronischen Baugruppen werden Kupfer-Keramik-Substrate üblicherweise mit Elektronikbauteilen bestückt. Dabei ist es erforderlich, dass das Elektronikbauteil mit dem Kupfer-Keramik-Substrat fest stoffschlüssig verbunden wird. Da die elektronischen Baugruppen im Betrieb oft hohen Temperaturen ausgesetzt sind, erfolgt die Verbindung des Elektronikbauteils mit dem Kupfer-Keramik-Substrat häufig über ein Sintermaterial, das ein Metall, typischerweise Silber und/oder Kupfer, umfasst. Beim Sintervorgang bildet die Metallkomponente des Sintermaterials eine stoffschlüssige Verbindung zu den zu verbindenden Oberflächen des Elektronikbauteils und des Kupfer-Keramik-Substrats aus. Aufgrund des hohen Schmelzpunktes von beispielswiese Silber bzw. Kupfer ist die entstehende Verbindung temperaturstabil. Um eine hohe Haftfestigkeit zu erreichen, wird die zu verbindende Oberfläche des Kupfer-Keramik-Substrats vor dem Sintervorgang üblicherweise mit einem Edelmetall, insbesondere Silber, Palladium oder Gold, beschichtet. Dies erleichtert eine Anbindung des Sintermaterials, da das darin enthaltene Metall leicht in die edelmetallhaltige Beschichtung des Kupfer-Keramik-Substrats diffundieren kann. Nachteilig daran ist jedoch, dass die Beschichtung des Kupfer-Keramik-Substrats mit einem Edelmetall technisch aufwändig ist und weitere Fertigungsschritte erfordert. Wünschenswert wäre es daher, Elektronikbauteile mit Kupfer-Keramik-Substraten fest und zuverlässig verbinden zu können, ohne dass die zu verbindende Oberfläche des Kupfer-Keramik-Substrats mit einer edelmetallhaltigen Beschichtung versehen ist.

Im Stand der Technik gibt es Hinweise darauf, dass die Kristallorientierung der Kupferkörner der Kupferschicht einen Einfluss auf die Eigenschaften des Kupfer-Keramik-Substrats hat. So beschreibt beispielsweise die JP 2016115821 A, dass eine möglichst homogene Kornorientierung der Kupferoberseite mit einem hohen Anteil der <100>-Kristallorientierung der Kupferkörner einen vorteilhaften Effekt auf die Ätzbarkeit der Kupferschicht eines Kupfer-Keramik-Substrats zeigt. Die EP 3922391 A1 befasst sich damit, wie die Körner der Kupferschicht so orientiert sein können, dass auftretende Spannungen während Temperaturwechselzyklen möglichst geringgehalten werden. Dafür sei eine Kristallorientierung im Querschliff vorteilhaft, bei der der Anteil der <001>-, <111>- und <101>-Kupferkörner maximal 45 % beträgt. Allerdings beschäftigt sich weder die JP 2016115821 A noch die EP 3922391 A1 mit der Verbindung zwischen dem Kupfer-Keramik-Substrat und einem Sintermaterial, das zur Verbindung der Kupferschicht mit einem Elektronikbauteil eingesetzt wird.

Daher besteht eine Aufgabe der vorliegenden Erfindung vorzugsweise darin, ein Kupfer-Keramik-Substrat bereitzustellen, das für eine feste und zuverlässige Verbindung mit einem Elektronikbauteil geeignet ist. Unter der Festigkeit einer Verbindung wird hierin insbesondere deren mechanische Festigkeit verstanden, also der Widerstand der Verbindung gegen das Ablösen beim Einwirken einer Kraft.

Eine weitere Aufgabe der vorliegenden Erfindung besteht vorzugsweise darin, ein Kupfer-Keramik-Substrat bereitzustellen, das für eine feste und zuverlässige Verbindung mit einem Elektronikbauteil geeignet ist, ohne dass es einer edelmetallhaltigen Beschichtung der zu verbindenden Oberseite des Kupfer-Keramik-Substrats bedarf.

Ein Beitrag zur Lösung dieser Aufgaben wird geleistet durch:
Ein Kupfer-Keramik-Substrat umfassend
a) einen Keramikkörper und
b) eine Kupferschicht, die mit dem Keramikkörper flächig verbunden ist, wobei die Kupferschicht eine Oberseite aufweist die Kupferkörner umfasst,
wobei wenigstens 20 % der Kupferkörner eine <101>-Orientierung in Normalrichtung aufweisen, wobei die Orientierung der Kupferkörner in einer Aufnahme der Oberseite der Kupferschicht mittels Elektronenrückstreubeugung (Electron Backscatter Diffraction, EBSD) bestimmt wird.

Bei der Kupferschicht eines Kupfer-Keramik-Substrates handelt es sich allgemein um ein polykristallines Material, das aus kleinen Kristalliten (die auch als Körner bezeichnet werden) besteht. Auf mikroskopischer Ebene können polykristalline Materialien anhand ihrer Kornstruktur (z.B. Korngrößenverteilungen, Orientierung der Körner, Form der Körner, Textur) eingehender charakterisiert werden. Eine dafür geeignete Methode ist die Elektronenrückstreubeugung.

Die Elektronenrückstreubeugungs-Methode (engl. electron backscatter diffraction, EBSD) ist ein Verfahren zur Bestimmung der Mikrostruktur einer Probe, beispielsweise der Kristallorientierung und Korngrößenverteilung. Dabei wird die Oberfläche der Probe unter einer Verkippung von 70° mit einem Elektronenstrahl bestrahlt und das entstehende Beugungsmuster der rückgestreuten Elektronen analysiert. Das zweidimensionale Abrastern der Probenoberfläche mit einem punktförmigen Elektronenstrahl in gleichem Abstand ermöglicht es, die zweidimensionale Verteilung der Kristallorientierung der Oberfläche zu ermitteln. Durch die relativ geringe Ausdringtiefe der Elektronen (50 - 80 nm bei einer Beschleunigungsspannung von 30 keV) handelt es sich um eine oberflächensensitive Methode, oder anders gesagt: nur die oberste Kristalllage einer Oberfläche trägt zum analysierten Signal bei. Außerdem lassen sich Informationen über die Größenverteilung der Kristallkörner gewinnen.

Die Erfindung stellt ferner die Verwendung eines Kupfer-Keramik-Substrats und ein Verfahren zur Herstellung einer festen Verbindung zwischen einem Kupfer-Keramik-Substrat und einem Elektronikbauteil bereit.

Das erfindungsgemäße Kupfer-Keramik-Substrat umfasst einen Keramikkörper.

Der Keramikkörper ist vorzugsweise ein Körper, der aus Keramik gebildet ist. Der Körper kann eine beliebige Geometrie einnehmen, ist aber vorzugsweise als Quader ausgestaltet. Der Keramikkörper weist Begrenzungsflächen auf, im Falle eines Quaders sechs Begrenzungsflächen. Der Keramikkörper weist vorzugsweise eine Hauptbegrenzungsfläche auf. Als Hauptbegrenzungsfläche wird hierin vorzugsweise die Begrenzungsfläche mit dem größten Flächeninhalt bezeichnet, die mit der Kupferschicht flächig verbunden ist. Die Hauptbegrenzungsfläche liegt vorzugsweise in der Haupterstreckungsebene oder verläuft parallel zu dieser. Demnach wird unter Haupterstreckungsebene des Keramikkörpers vorzugsweise eine Ebene verstanden, die parallel zur Hauptbegrenzungsfläche des Keramikkörpers verläuft oder diese umschließt.

Die Keramik des Keramikkörpers ist vorzugsweise eine isolierende Keramik. Gemäß einer bevorzugten Ausführungsform ist die Keramik aus der Gruppe ausgewählt, die aus Oxidkeramiken, Nitridkeramiken und Carbidkeramiken besteht. Gemäß einer weiteren bevorzugten Ausführungsform ist die Keramik aus der Gruppe ausgewählt, die aus Metalloxidkeramiken, Siliziumoxidkeramiken, Metallnitridkeramiken, Siliziumnitridkeramiken, Bornitridkeramiken und Borcarbidkeramiken besteht. Gemäß einer besonders bevorzugten Ausführungsform ist die Keramik aus der Gruppe ausgewählt, die aus Aluminiumnitridkeramiken, Siliziumnitridkeramiken und Aluminiumoxidkeramiken (wie zum Beispiel ZTA ("Zirconia Toughened Alumina") -Keramiken) besteht. Gemäß einer weiteren ganz besonders bevorzugten Ausführungsform besteht der Keramikkörper aus (1) wenigstens einem Element, das aus der Gruppe ausgewählt ist, die aus Silizium und Aluminium besteht, (2) wenigstens einem Element, das aus der Gruppe ausgewählt ist, die aus Sauerstoff und Stickstoff besteht, optional (3) wenigstens einem Element, das aus der Gruppe ausgewählt ist, die aus (3a) Metallen der seltenen Erden, (3b) Metallen der zweiten Hauptgruppe des Periodensystems der Elemente, (3c) Zirkonium, (3d) Kupfer, (3e) Molybdän und (3f) Silizium besteht, und optional (4) unvermeidlichen Verunreinigungen. Gemäß noch einer weiteren ganz besonders bevorzugten Ausführungsform ist der Keramikkörper frei von Bismut, Gallium und Zink.

Der Keramikkörper weist vorzugsweise eine Dicke von 0,05 - 10 mm, mehr bevorzugt im Bereich von 0,1 - 5 mm und besonders bevorzugt im Bereich von 0,15 - 3 mm auf.

Das erfindungsgemäße Kupfer-Keramik-Substrat umfasst eine Kupferschicht, die mit dem Keramikkörper flächig verbunden ist.

Die Kupferschicht umfasst Kupfer. Bevorzugt beträgt der Anteil an Kupfer wenigstens 90 Gewichtsprozent (Gew.-%), bevorzugter wenigstens 95 Gew.-%, noch bevorzugter wenigstens 99 Gew.-% und besonders bevorzugt wenigstens 99,9 Gew.-%, bezogen auf das Gesamtgewicht der Kupferschicht. Gemäß einer bevorzugten Ausführungsform besteht die Kupferschicht aus Kupfer und unvermeidlichen Verunreinigungen. Unter unvermeidlichen Verunreinigungen sind hierin Element und Komponenten zu verstehen, die durch den Herstellprozess der Kupferschicht und/oder den Herstellprozess des Kupfer-Keramik-Substrats in die Kupferschicht gelangen, dieser aber nicht beabsichtigt zugefügt werden.

Die Kupferschicht weist vorzugsweise eine Dicke im Bereich von 0,01 - 10 mm auf, besonders bevorzugt im Bereich von 0,03 - 5 mm und ganz besonders bevorzugt im Bereich von 0,05 - 3 mm.

Die Kupferschicht ist mit dem Keramikkörper vorzugsweise stoffschlüssig verbunden. Gemäß einer bevorzugten Ausführungsform ist die Kupferschicht mit dem Keramikkörper durch ein Verfahren verbunden, das aus der Gruppe ausgewählt ist, die aus DCB-Verfahren (Direct Copper Bonding) und Aktivlotverfahren, insbesondere AMB-Verfahren (Active Metal Brazing), ausgewählt ist.

Bei der Verbindung einer Kupferschicht mit einem Keramikkörper durch ein DCB-Verfahren wird vorzugsweise eine Kupferfolie mit einem Keramikkörper verbunden, wobei an der Oberfläche der Kupferfolie durch Erhitzen auf eine Temperatur im Bereich von 1025 - 1083°C, insbesondere auf eine Temperatur von 1071°C, eine Aufschmelzschicht erzeugt wird, die eine chemische Verbindung umfassend Kupfer und ein reaktives Gas, bevorzugt Sauerstoff, enthält. Diese Aufschmelzschicht bildet ein Eutektikum mit einer Schmelztemperatur unter der Schmelztemperatur von Kupfer, so dass durch Auflegen der Kupferfolie auf den Keramikkörper und durch Erhitzen eine formschlüssige Verbindung zwischen der Kupferfolie und dem Keramikkörper erzeugt wird. Ein solches Verfahren ist zum Beispiel in der deutschen Patentanmeldung DE2319854 A1 offenbart.

Bei der Verbindung einer Kupferschicht mit einem Keramikkörper durch ein AMB-Verfahren wird vorzugsweise ein Aktivlot zur Verbindung einer Kupferfolie mit einem Keramikkörper verwendet. Hierzu wird das Aktivlot vorzugsweise zwischen dem Keramikkörper und der Kupferfolie positioniert und aufgeschmolzen (besonders bevorzugt bei einer Temperatur im Bereich von 800 - 1000°C). Beim Erstarren des Aktivlotes bildet sich zwischen dem Keramikkörper und der Kupferfolie eine formschlüssige Verbindung aus. Folglich kann die Kupferschicht mit dem Keramikkörper auch über eine Verbindungsschicht flächig verbunden sein. Bei der Verbindungsschicht kann es sich zum Beispiel um eine Aktivlotschicht oder eine Diffusionsschicht handeln. Ein solches Verfahren ist zum Beispiel in der europäischen Patentanmeldung EP153618 A2 offenbart.

Die Kupferschicht ist mit dem Keramikkörper flächig verbunden. Dementsprechend ist die Kupferschicht flächig vorzugsweise mit der Hauptbegrenzungsfläche des Keramikkörpers verbunden. Die Kupferschicht ist vorzugsweise nicht mit der gesamten Hauptbegrenzungsfläche des Keramikkörpers verbunden. Insbesondere kann es vorgesehen sein, dass die Hauptbegrenzungsfläche des Keramikkörpers größer ist als die Fläche der mit dem Keramikkörper verbundenen Kupferschicht. In diesen Fällen steht die Hauptbegrenzungsfläche des Keramikkörpers über. Darüber hinaus kann es vorgesehen sein, dass die Kupferschicht strukturiert ist. Unter Strukturierungen werden vorzugsweise Ausnehmungen in der Kupferschicht verstanden, um einzelne Abschnitte der Kupferschicht voneinander zu trennen und damit elektrisch voneinander zu isolieren. Derartige Strukturierungen werden üblicherweise durch Ätztechniken erzeugt.

Die Kupferschicht weist eine Oberseite auf. Die Oberseite der Kupferschicht ist vorzugsweise die Seite der Kupferschicht, die dem Keramikkörper, insbesondere der Hauptbegrenzungsfläche des Keramikkörpers, abgewandt ist. Dementsprechend ist die Oberseite der Kupferschicht vorzugsweise die Seite der Kupferschicht, die für die stoffschlüssige Verbindung mit einem Elektronikbauteil vorgesehen ist.

Die Oberseite der Kupferschicht umfasst Kupferkörner. Die Oberseite ist vorzugsweise so beschaffen, dass sie mit einem Elektronikbauteil unter Verwendung von einem Sintermaterial, das insbesondere Silber und/oder Kupfer umfasst, bevorzugt Silber, fest und zuverlässig verbunden werden kann. Hierzu weist die Oberseite der Kupferschicht eine besondere Verteilung der Kristallorientierungen der sie bildenden Kupferkörner auf, nämlich einen Anteil der Kupferkörner mit <101>-Orientierung in Normalrichtung von wenigstens 20 %. Die Orientierung der Kupferkörner wird mittels einer Aufnahme der Oberseite der Kupferschicht mittels Elektronenrückstreubeugung (Electron Backscatter Diffraction, EBSD) bestimmt.

Mit anderen Worten weisen in einer Aufnahme der Oberseite der Kupferschicht mittels Elektronenrückstreubeugung wenigstens 20 % der Kupferkörner eine <101>-Orientierung in Normalrichtung auf.

Überraschenderweise wurde festgestellt, dass ein Kupfer-Keramik-Substrat, das so beschaffen ist, dass die Kupferkörner, die die Oberseite der Kupferschicht bilden, einen Anteil der <101>-Kristallorientierung von wenigstens 20 % aufweisen, mit einem Elektronikbauteil unter Verwendung von Sintermaterial, das Silber und/oder Kupfer umfasst, fest und zuverlässig verbunden werden kann. Im Rahmen dieser Anmeldung werden die Bezeichnungen "Kupferkörner" und "Kupferkristalle" synonym verwendet, gleiches gilt für die Bezeichnungen "Kornorientierung" und "Kristallorientierung".

Im Stand der Technik wird üblicherweise die Kristallorientierung im Querschnitt der Kupferschicht analysiert. Im vorliegenden Fall wurde überraschenderweise gefunden, dass für die Festigkeit der Sinterverbindung insbesondere die Kornorientierung in der Oberflächenebene relevant ist.

Da es sich bei der Elektronenrückstreubeugungs-Analyse um eine Methode handelt, die durch die geringe Ausdringtiefe der signalgebenden Elektronen nur die oberste Kornlage der Oberfläche erfasst, entspricht die Kristallorientierung der Kupferkörner der Oberfläche der obersten Lage der Kupferkörner.

In einer Aufnahme der Oberseite der Kupferschicht mittels Elektronenrückstreubeugung weisen wenigstens 20 % der Körner eine <101>-Orientierung in Normalrichtung auf. Die Prozentangabe bezieht sich auf die Gesamt-Oberfläche der Oberseite der Kupferschicht. Bevorzugt weisen wenigstens 25 % der Körner eine <101>-Orientierung in Normalrichtung auf, noch bevorzugter wenigstens 30 %, weiter bevorzugt wenigstens 40 %. Beispielsweise liegt der Anteil der <101>- Kristallorientierung im Bereich von 20 - 90 %, besonders bevorzugt im Bereich von 25 - 80 %, ganz besonders bevorzugt im Bereich von 30 - 70 %.

Die Kristallorientierung der Kupfer-Körner der Oberseite wird in Normalrichtung mittels einer Elektronenrückstreubeugungs-Aufnahme bestimmt. Wie dem Fachmann bekannt, ist unter der Normalrichtung die Richtung senkrecht zur Oberflächenebene zu verstehen. Mit anderen Worten wird mittels der Elektronenrückstreubeugungs-Aufnahme die Kristallorientierung der Kupfer-Körner in einer Ebene bestimmt, die parallel zur Haupterstreckungsebene der Oberseite der Kupferschicht liegt oder koplanar mit dieser ist. Die Kristallorientierung der Kupfer-Körner wird also nicht im Querschnitt der Kupferschicht bestimmt.

Bevorzugt wird die Kristallorientierung der Kupfer-Körner mit einem Toleranzwinkel von 10° in Bezug auf die Oberflächennormale bestimmt. Wie dem Fachmann bekannt, definiert der Toleranzwinkel, bis wann zwei benachbarte Punkte in der Elektronenrückstreubeugungs-Karte zu demselben Korn gehören. So führt ein größerer Toleranzwinkel bei der Zuordnung zum Verschmelzen zweier benachbarter Körner zu einem großen Korn, während ein kleiner Toleranzwinkel sensitiv für leicht verkippte Körner an Korngrenzen ist und diese voneinander unterscheidet.

Bevorzugt erfolgt die Aufnahme der Oberseite der Kupferschicht mittels Elektronenrückstreubeugung zur Bestimmung der Kristallorientierung der Kupfer-Körner mit einer Schrittweite von 10 µm. Wie dem Fachmann bekannt, beschreibt die Schrittweite den Abstand zwischen den einzelnen durch den Elektronenstrahl erfassten Messpunkten und bestimmt die Genauigkeit der Messung. Je kleiner die Schrittweite gewählt wird, desto höher ist die laterale Auflösung der Untersuchungsergebnisse, jedoch verlängert sich dadurch auch die Analysendauer.

Gemäß einer bevorzugten Ausführungsform weist die Oberseite der Kupferschicht einen Anteil der <100>-Kristallorientierung der Kupferkörner von wenigstens 0,5 % auf, bevorzugter wenigstens 1 %, noch bevorzugter wenigstens 1,5 %. Die <100>-Kristallorientierung der Kupfer-Körner wird ebenfalls in Normalrichtung der Oberseite mittels einer Elektronenrückstreubeugungs-Aufnahme bestimmt. Bevorzugt liegt der Anteil der <100>-Kristallorientierung im Bereich von 0,5 - 20 %, besonders bevorzugt im Bereich von 1 - 15 %, ganz besonders bevorzugt im Bereich von 1,5 - 10 %.

Gemäß einer bevorzugten Ausführungsform beträgt die Summe der <101>-Kristallorientierung und der <100>-Kristallorientierung der Kupferkörner mindestens 20,5 %, bevorzugter mindestens 25,5 %, noch bevorzugter mindestens 30,5 %, weiter bevorzugt mindestens 40,5 %. Bevorzugt beträgt die Summe der <101>-Kristallorientierung und der <100>-Kristallorientierung der Kupferkörner zwischen 20,5 - 95 %, besonders bevorzugt zwischen 25,5 - 90 %, ganz besonders bevorzugt zwischen von 30,5 - 85 %.

Gemäß einer bevorzugten Ausführungsform weist die Oberseite der Kupferschicht einen Anteil der <111 >-Kristallorientierung der Kupferkörner von weniger als 10 % auf, bevorzugter weniger als 8 %, noch bevorzugter weniger als 5 %. Die <111 >-Kristallorientierung der Kupfer-Körner wird ebenfalls in Normalrichtung der Oberseite mittels einer Elektronenrückstreubeugungs-Aufnahme bestimmt. Bevorzugt liegt der Anteil der <111>- Kristallorientierung im Bereich von 0,05 - 10 %, besonders bevorzugt im Bereich von 0,1 - 8 %, ganz besonders bevorzugt im Bereich von 0,5 - 5 %.

Neben den beschriebenen <101>-, <100>- und <111>-Orientierungen können die Kupferkörner der Oberseite der Kupferschicht auch weitere Orientierungen aufweisen. Die Summe aller Orientierungen beträgt 100 %.

Durch Verwendung einer Kupferfolie mit geeigneter Orientierung der Kupferkörner bei der Herstellung des Kupfer-Keramik-Substrats können die gewünschten Kristallorientierungen im Kupfer-Keramik-Substrat eingestellt werden. Geeignete Kupferfolien sind kommerziell erhältlich oder können auf fachübliche Weise hergestellt werden. Geeignete Methoden, mit denen die Kristallorientierung der Körner in der Kupferfolie eingestellt werden können, sind dem Fachmann bekannt. Die Einstellung der Kristallorientierung kann beispielsweise durch die Walzbedingungen während der Herstellung der Kupferfolie, insbesondere durch den Druck, die Walzgeschwindigkeit, den Verformungsfaktor und die Temperatur, eine thermische (Nach-)Behandlung der Kupferfolie, insbesondere Temperatur und Dauer der Temperaturbehandlung, und/oder mechanische Nachbehandlung, erfolgen.

Die Orientierung der Kupferkörner der Kupferschicht des Kupfer-Keramik-Substrats kann außerdem während der Herstellung des Kupfer-Keramik-Substrats eingestellt werden, insbesondere während einem Schritt, in dem der Keramikkörper mit einer Kupferfolie verbunden wird. Die Einstellung der Kristallorientierung kann beispielsweise durch das verwendete Verfahren, die Prozessbedingungen, insbesondere Temperatur, Dauer der Temperaturbehandlung, Atmosphärenbedingungen und verwendete Hilfsmittel wie Lotmaterialien beeinflusst werden.

Die Orientierung der Kupferkörner der Kupferschicht des Kupfer-Keramik-Substrats kann ebenso durch dem Fachmann bekannte Verfahren eingestellt werden, beispielsweise durch thermische Behandlung, insbesondere Temperatur, Dauer der Temperaturbehandlung und Umgebungsatmosphäre, und/oder mechanische Behandlung. Die Einstellung der Orientierung der Kupferkörner nach der Herstellung des Kupfer-Keramik-Substrats ist insbesondere dann vorteilhaft, wenn die Kupferschicht bzw. die für ihre Herstellung eingesetzte Kupferfolie, vorher keiner thermischen Behandlung unterzogen wurde.

Bevorzugt liegt die mittlere Größe der Kupferkörner der Oberseite der Kupferschicht im Bereich von 10 - 1200 µm, noch bevorzugter im Bereich von 50 - 1100 µm, insbesondere im Bereich von 100 - 1000 µm. Unter der Größe der Kupferkörner wird im Rahmen der vorliegenden Anmeldung der flächengewichtete Mittelwert des Durchmessers verstanden. Die mittlere Größe der Kupferkörner wird bevorzugt mit einem Toleranzwinkel von 5° gemäß der zum Anmeldetag gültigen Version von ASTM E2627 bestimmt.

Durch Verwendung einer Kupferfolie mit geeigneter Größe der Kupferkörner bei der Herstellung des Kupfer-Keramik-Substrats können die gewünschten Kupfer-Korngrößen im Kupfer-Keramik-Substrat eingestellt werden. Geeignete Kupferfolien sind kommerziell erhältlich oder können auf fachübliche Weise hergestellt werden. Geeignete Methoden, mit denen die Größe der Körner in der Kupferfolie eingestellt werden können, sind dem Fachmann bekannt. Die Größe der Kupferkörner der Kupferschicht des Kupfer-Keramik-Substrats kann außerdem während der Herstellung des Kupfer-Keramik-Substrats eingestellt werden, insbesondere während einem Schritt, in dem der Keramikkörper mit einer Kupferfolie verbunden wird. Die Größe der Kupferkörner der Kupferschicht des Kupfer-Keramik-Substrats kann ebenso durch dem Fachmann bekannte Verfahren eingestellt werden, beispielsweise durch thermische Behandlung, insbesondere Temperatur, Dauer der Temperaturbehandlung und Umgebungsatmosphäre, und/oder mechanische Behandlung.

Gemäß einer bevorzugten Ausführungsform umfasst das Kupfer-Keramik-Substrat eine weitere (zweite) Metallschicht, die flächig mit dem Keramikkörper verbunden ist. Die weitere Metallschicht ist vorzugsweise mit der der Hauptbegrenzungsfläche der Keramik abgewandten (und vorzugsweise zu dieser parallel verlaufenden) Begrenzungsfläche flächig verbunden. Bei der weiteren (zweiten) Metallschicht kann es sich ebenfalls um eine Kupferschicht handeln, andere Metalle sind aber ebenso möglich, beispielsweise Aluminium. Eine weitere (zweite) Kupferschicht kann wie die (erste) Kupferschicht beschaffen sein oder in ihrer Beschaffenheit von der (ersten) Kupferschicht abweichen. Zur Beschaffenheit der weiteren (zweiten) Kupferschicht wird auf die vorstehenden Erläuterungen Bezug genommen.

Das Verfahren zur Herstellung des erfindungsgemäßen Kupfer-Keramik-Substrats ist nicht weiter eingeschränkt.

Vorzugsweise umfasst das Verfahren zur Herstellung des erfindungsgemäßen Kupfer-Keramik-Substrats die Schritte:
(a) Bereitstellung eines Keramikkörpers;
(b) Bereitstellung einer Kupferfolie;
(c) Verbinden des Keramikkörpers mit der Kupferfolie.

Zu geeigneten Verfahren zum Verbinden des Keramikkörpers mit der Kupferfolie kann auf die vorstehenden Angaben Bezug genommen werden.

In bevorzugten Ausführungsformen weisen wenigstens 20 % der Körner der Oberseite der bereitgestellten Kupferfolie eine <101>-Orientierung in Normalrichtung auf. Die Orientierung der Kupferkörner wird hierbei in einer Aufnahme der Oberseite der Kupferschicht mittels Elektronenrückstreubeugung bestimmt.

Geeignete Verfahren zur Herstellung einer entsprechenden Kupferfolie sind dem Fachmann bekannt, zu geeigneten Verfahren kann auf die vorstehenden Angaben Bezug genommen werden. Die Kristallorientierung und/oder Korngröße der Kupferfolie kann insbesondere durch die Walzbedingungen, insbesondere durch den Druck, den Verformungsfaktor und die Temperatur, sowie die Temperatur und Dauer von einem oder mehrerer thermischer (Nach-) Behandlungsschritte während der Herstellung der Kupferfolie beeinflusst werden.

In einer alternativen Ausführungsform umfasst das Verfahren zur Herstellung des erfindungsgemäßen Kupfer-Keramik-Substrats einen weiteren Schritt (d), bei dem die Oberseite des Kupfer-Keramik-Substrats einem Behandlungsschritt unterzogen wird, nach dem wenigstens 20 % der Körner der Kupferschicht eine <101>-Orientierung in Normalrichtung aufweisen. Geeignete Verfahren zur Nachbehandlung der Kupferschicht sind dem Fachmann bekannt, zu geeigneten Verfahren kann auf die vorstehenden Angaben Bezug genommen werden.

Die Kristallorientierung und/oder Korngröße der Kupferkörner der Kupferschicht kann insbesondere durch eine thermische Behandlung und/oder eine mechanische Behandlung eingestellt werden.

Das erfindungsgemäße Kupfer-Keramik-Substrat wird vorzugsweise zum stoffschlüssigen Verbinden mit einem Elektronikbauteil verwendet.

Unter Elektronikbauteil wird vorzugsweise ein elektronisches oder elektrisches Bauelement verstanden. Das Elektronikbauteil ist vorzugsweise aus der Gruppe ausgewählt, die aus Halbleiterkomponenten besteht. Die Halbleiterkomponenten sind vorzugsweise aus der Gruppe ausgewählt, die aus Transistoren, Dioden und integrierten Schaltkreisen besteht.

Gemäß einer bevorzugten Ausführungsform ist das Kupfer-Keramik-Substrat noch zum festen Verbinden mit einem Elektronikbauteil geeignet. Daher steht die Oberseite des Kupfer-Keramik-Substrats vorzugsweise nicht mit einer Verbindungsschicht in Kontakt, die eine feste Verbindung mit einem weiteren Element, besonders bevorzugt einem Elektronikbauteil, ausgebildet hat.

Die Erfindung stellt ein Verfahren zur Herstellung einer festen Verbindung zwischen einem Kupfer-Keramik-Substrat und einem Elektronikbauteil bereit, bei dem man:
a) ein Kupfer-Keramik-Substrat bereitstellt, umfassend (i) einen Keramikkörper und (ii) eine Kupferschicht, die mit dem Keramikkörper flächig verbunden ist, wobei die Kupferschicht eine Oberseite aufweist die Kupferkörner umfasst, wobei wenigstens 20 % der Kupferkörner eine <101>-Orientierung in Normalrichtung aufweisen, wobei die Orientierung der Kupferkörner in einer Aufnahme der Oberseite der Kupferschicht mittels Elektronenrückstreubeugung (Electron Backscatter Diffraction, EBSD) bestimmt wird;
b) ein Elektronikbauteil bereitstellt,
c) ein Sintermaterial bereitstellt,
d) das Elektronikbauteil, das Kupfer-Keramik-Substrat und das Sintermaterial so positioniert, dass eine Anordnung geschaffen wird, bei der das Elektronikbauteil mit der Oberseite der Kupferschicht des Kupfer-Keramik-Substrats über das Sintermaterial in Kontakt steht, und
e) die Anordnung einer Behandlung unterzieht, bei der eine Sinterverbindung zwischen dem Elektronikbauteil und dem Kupfer-Keramik-Substrat entsteht.

Bei dem Verfahren wird ein Kupfer-Keramik-Substrat bereitgestellt.

Bei dem Kupfer-Keramik-Substrat handelt es sich um ein wie hierin beschriebenes Kupfer-Keramik-Substrat.

Demnach umfasst das Kupfer-Keramik-Substrat
a) einen Keramikkörper und
b) eine Kupferschicht, die mit dem Keramikkörper flächig verbunden ist, wobei die Kupferschicht eine Oberseite aufweist, wobei wenigstens 20 % der Kupferkörner eine <101 >-Orientierung in Normalrichtung aufweisen, wobei die Orientierung der Kupferkörner in einer Aufnahme der Oberseite der Kupferschicht mittels Elektronenrückstreubeugung (Electron Backscatter Diffraction, EBSD) bestimmt wird.

Bei dem Verfahren wird ein Elektronikbauteil bereitgestellt.

Zur Beschaffenheit des Elektronikbauteils kann auf die vorstehenden Angaben Bezug genommen werden.

Bei dem Verfahren wird ein Sintermaterial bereitgestellt.

Das Sintermaterial ist vorzugsweise aus der Gruppe ausgewählt, die aus Sinterpasten, Sinterfolien und Sintervorformen besteht.

Bevorzugt umfasst das Sintermaterial Silber und/oder Kupfer, besonders bevorzugt umfasst das Sintermaterial Silber.

Gemäß einer bevorzugten Ausführungsform umfasst das Sintermaterial eine Sinterpaste. Bei der Sinterpaste handelt es sich vorzugsweise um eine fachübliche Sinterpaste. Vorzugsweise umfasst die Sinterpaste ein Metall, beispielswiese Silber und/oder Kupfer, vorzugsweise Silber, und eine organische Verbindung.

Es kann bevorzugt sein, dass das Metall in der Sinterpaste als Metallpartikel vorliegt. Auch ummantelte Metallpartikel sind möglich, beispielsweise solche, bei denen insbesondere ein Mantel aus Silber oder Kupfer einen Kern aus einem anderen Metall umschließt. Bei dem Metall des Kerns kann es sich um ein unedleres Metall, beispielsweise Nickel oder Kupfer handeln. Die Metallpartikel können eine beliebige Form annehmen und daher beispielsweise als sphärische Metallpartikel, Metallflakes oder unregelmäßig geformte Metallpartikel vorliegen.

Die mittlere Größe der Metallpartikel liegt bevorzugt im Bereich von 0,05 - 20 µm, bevorzugter im Bereich von 0,1 - 15 µm, noch bevorzugter im Bereich von 0,2 - 10 µm. Unter der mittleren Partikelgröße (d₅₀) ist hierin der mittels Laserbeugung bestimmbaren Primärteilchendurchmesser zu verstehen, der von einem Volumenanteil von 50 % der Teilchen unterschritten wird. Laserbeugungsmessungen können mit einem entsprechenden Teilchengrößenmessgerät, beispielsweise einem Mastersizer 3000 oder einem Mastersizer 2000 von Malvern Instruments nach der Nassbestimmungsmethode durchgeführt werden. Bei der Nassbestimmungsmethode können im Rahmen der Probenvorbereitung beispielsweise 1 g Metallpartikel vom Typ (i) in 200 ml Ethanol mittels Ultraschall dispergiert werden

Die organische Verbindung ist vorzugsweise aus der Gruppe ausgewählt, die aus Dispersionsmitteln, Bindemitteln, Fettsäuren und Mischungen davon besteht. Die Dispersionsmittel können aus fachüblichen Dispersionsmitteln ausgewählt sein. Ein beispielhaftes Dispersionsmittel ist Terpineol. Die Bindemittel können aus fachüblichen Polymeren ausgewählt sein. Beispielhaft genannt seien Zellulosederivate, so zum Beispiel Methylzellulose, Ethylzellulose, Ethylmethylzellulose, Carboxyzellullose und Hydroxypropylzellullose. Die Fettsäuren können aus fachüblichen Fettsäuren ausgewählt sein. Vorzugsweise sind die Fettsäuren aus der Gruppe ausgewählt, die aus Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/ Icosansäure), Behensäure (Docosansäure) und Lignocerinsäure (Tetracosansäure) besteht.

Gemäß einer weiteren bevorzugten Ausführungsform umfasst das Sintermaterial eine Sinterfolie. Vorzugsweise handelt es sich bei der Sinterfolie um eine fachübliche Sinterfolie, wie sie zum Beispiel in der europäischen Patentanmeldung EP3154729 A1 offenbart ist. Eine Sinterfolie kann daher zum Beispiel eine Sinterpaste, die Metallpartikel (insbesondere Silberpartikel) und ein Bindemittel umfasst, aufweisen, die auf einem Trägersubstrat vorgetrocknet vorliegt. Die Sinterfolie kann zum Beispiel eine Dicke im Bereich von 5 - 300 µm aufweisen.

Gemäß einer weiteren bevorzugten Ausführungsform umfasst das Sintermaterial eine Sintervorform. Vorzugsweise handelt es sich bei der Sintervorform um eine fachübliche Sintervorform, wie sie zum Beispiel in der europäischen Patentanmeldung EP2428293 A2 offenbart ist.

Bei dem Verfahren wird ein Elektronikbauteil bereitgestellt. Zur Beschaffenheit des Elektronikbauteils kann auf die vorstehenden Angaben Bezug genommen werden.

Bei dem Verfahren werden das Elektronikbauteil, das Kupfer-Keramik-Substrat und das Sintermaterial so positioniert, dass eine Anordnung geschaffen wird, bei der das Elektronikbauteil mit der Oberseite der Kupferschicht des Kupfer-Keramik-Substrats über das Sintermaterial in Kontakt steht.

Das Verfahren zum Schaffen der Anordnung ist nicht weiter eingeschränkt.

Gemäß einer bevorzugten Ausführungsform wird hierzu das Sintermaterial auf die Oberseite der Kupferschicht des Kupfer-Keramik-Substrats aufgebracht. Das Aufbringen des Sintermaterials auf die Oberseite der Kupferschicht des Kupfer-Keramik-Substrats kann durch fachübliche Verfahren erfolgen. Vorzugsweise erfolgt das Aufbringen des Sintermaterials im Fall einer Sinterpaste durch Jetten, Dispensen, Sprühen, Pinseln, Tupfen, Tauchen oder Drucken, insbesondere Siebdrucken oder Schablonendrucken, und im Fall einer Sinterfolie oder einer Sintervorform durch einfaches Auflegen. Danach kann das Elektronikbauteil mit der zu verbindenden Oberseite auf dem Sintermaterial positioniert werden, um eine Anordnung zu schaffen, bei der das Elektronikbauteil mit der Oberseite der Kupferschicht des Kupfer-Keramik-Substrats über das Sintermaterial in Kontakt steht.

Gemäß einer alternativen bevorzugten Ausführungsform wird das Sintermaterial auf die zu verbindende Oberseite des Elektronikbauteils aufgebracht. Das Aufbringen des Sintermaterials auf die die zu verbindende Oberseite des Elektronikbauteils kann durch fachübliche Verfahren erfolgen. Vorzugsweise erfolgt das Aufbringen des Sintermaterials im Fall einer Sinterpaste durch Jetten, Dispensen, Sprühen, Pinseln, Tupfen, Tauchen oder Drucken, insbesondere Siebdrucken oder Schablonendrucken, und im Fall einer Sinterfolie oder einer Sintervorform durch einfaches Auflegen. Danach kann das Kupfer-Keramik-Substrat mit der Oberseite der Kupferschicht auf dem Sintermaterial positioniert werden, um eine Anordnung zu schaffen, bei der das Elektronikbauteil mit der Oberseite der Kupferschicht des Kupfer-Keramik-Substrats über das Sintermaterial in Kontakt steht.

Bei dem Verfahren wird die Anordnung einer Behandlung unterzogen, bei der eine Sinterverbindung zwischen dem Elektronikbauteil und dem Kupfer-Keramik-Substrat entsteht.

Gemäß einer bevorzugten Ausführungsform erfolgt die Behandlung durch eine Temperaturbeaufschlagung und/oder eine Druckbeaufschlagung.

Bei einer Temperaturbeaufschlagung wird die Anordnung vorzugsweise einer Temperatur im Bereich von 150 - 350°C, mehr bevorzugt einer Temperatur im Bereich von 180 - 280°C und besonders bevorzugt einer Temperatur im Bereich von 200 - 250°C ausgesetzt.

Bei einer Druckbeaufschlagung wird die Anordnung vorzugsweise einem Druck im Bereich von >0 - 300 bar, besonders bevorzugt einem Druck im Bereich von 0,1 - 30 bar und ganz besonders bevorzugt einem Druck im Bereich von 0,2 - 10 bar ausgesetzt.

Bei dem Verfahren entsteht eine Sinterverbindung und damit eine feste Verbindung zwischen dem Elektronikbauteil und dem Kupfer-Keramik-Substrat.

### Methodenbeschreibung:

### Bestimmung der Kristallorientierung und Korngrößen

Die Mikrostruktur der Kupferoberfläche (Kornorientierung und Korngröße) wurde mittels Rasterelektronenmikroskopie (REM; MIRA3-XM; TESCAN, Brno, Tschechien) mit Elektronenrückstreubeugung (engl. Electron BackScatter Diffraction, EBSD) (DigiView-IV, EDAX Inc., Mahwah, New Jersey, USA) untersucht.

Die Analyse der Oberseite der Kupferschicht durch EBSD und die Auswertung der erhaltenen Aufnahmen erfolgen dabei vorzugsweise gemäß dem folgenden Verfahren:
EBSD-Messungen wurden mit einer Schrittweite von 10 µm und einer Beschleunigungsspannung von 20 kV durchgeführt. Die Probe war dabei um 70° gegenüber dem einfallenden Elektronenstrahl gekippt. Von jedem Probesubstrat wurden 4 vorbestimmte Messbereiche (5 x 5 mm) untersucht.

Die erhaltenen Messdaten wurden mit der Software EDAX APEX EBSD ausgewertet. Bei der Nachbearbeitung wurden eine Standardisierung des Konfidenzindex (CI) und eine CI-Filterung verwendet, wobei Punkte mit einem Konfidenzindex unter 0,1 ausgeschlossen wurden.

Die Bestimmung der Kristallorientierungen erfolgte unter Verwendung eines Toleranzwinkels von 10°. Dafür wurde Karten der inversen Polfiguren (IPF) der <001>-, <101>-, <111>- und <112>-Orientierungsfamilien der Messbereiche berechnet.

Die mittlere Größe der Kupferkörner wurde mit einem Toleranzwinkel von 5° gemäß ASTM E2627 gemäß der zum Anmeldetag gültigen Version ausgewertet. Die mittlere Größe der Kupferkörner wurde als flächengewichteter Mittelwert des Durchmessers bestimmt, der auch als mittlerer äquivalenter Kreisdurchmesser bezeichnet wird. Dabei werden zunächst die Korngrenzen der Kupferkörner bestimmt und deren jeweilige Kornfläche berechnet. Anschließend wird für jedes Korn der Durchmesser eines kreisförmigen Korns gleicher Fläche bestimmt. Zur Berechnung der mittleren Größe werden die so bestimmten Durchmesser der einzelnen Körner gemäß dem Flächenanteil des jeweiligen Kupferkorns an der untersuchten Gesamtfläche gewichtet.

### Bestimmung der mechanischen Haftfestigkeit von Siliziumchips auf den Kupfer-Keramik-Substraten und der Haftfestigkeit der Silbersinterschicht

Um eine standortspezifische EBSD-Oberflächencharakterisierung zu erhalten, wurden vor dem Sintern für jedes Substrat in Abstimmung mit den vorgesehenen Chippositionen vier Messbereiche (5 x 5 mm) festgelegt. Dies wurde durch die Ausrichtung der Schablone für den Pastenauftrag speziell auf den Substraten erreicht. Die Bereiche wurden wie oben beschrieben zunächst durch Aufnahme einer EBSD-Karte charakterisiert.

Vor der Bestückung mit Siliziumchips wurden die Kupfer-Keramik-Substrate gereinigt. Hierzu wurde das Kupfer-Keramik-Substrat in der Kammer einer Lötanlage (PINK Vadu 200) zunächst Vakuum, dann Ameisensäure bei einem Atmosphärendruck von 500 mbar und einer Temperatur von 180 °C und anschließend Stickstoff ausgesetzt.

Zur Bestückung mit Siliziumchips wurde das Kupfer-Keramik-Substrat mithilfe einer 150 µm dicken Druckschablone und eines Rakels mit einer Sinterpaste (ASP 338-28 von Heraeus) bedruckt. Die Sinterpaste wurde in einem Konvektionsofen bei 140 °C für 20 min in einer Stickstoffatmosphäre mit einem Restsauerstoffgehalt von 50 ppm vorgetrocknet und anschließend abgekühlt. Auf der vorgetrockneten Sinterpaste wurden Siliziumchips mit der Abmessung 4 x 4 mm (Dicke = 250 µm), die eine unterseitige Metallisierung (100 nm Aluminium, 50 nm Titan, 100 nm Nickel und schließlich 700 nm Silber) aufwiesen, positioniert. Das Sintern erfolgte in einer Sinterpresse (PINK GmbH, Wertheim, Deutschland) für eine Dauer von 3 min in einer Stickstoffatmosphäre bei einem Druck von 10 MPa und einer Temperatur von 230°C.

Anschließend erfolgte die Abscherung der Chips. Dafür wurde ein Bondtester (Dage 4000 Plus; Nordson Corporation, Westlake Ohio, USA) verwendet. Das Bauteil wurde hierzu zunächst in die Vorrichtung eingespannt. Für die Abscherung wurde ein Schermeißel mit einer Breite von 6 mm aus Stahl verwendet, der mit ansteigender Kraft auf das Bauteil einwirkte, bis es zu einem Ablösen der Siliziumchips von den Kupfer-Keramik-Substraten kam. Der Widerstand gegen das Abscheren, bis sich die Siliziumchips lösten, wird als Scherfestigkeit bezeichnet.

Nach dem Abscheren wurden die vorbestimmten Messbereiche des Substrats mittels REM (ebenfalls MIRA3-XM von TESCAN) mit energiedispersiver Röntgenspektroskopie (energy dispersive X-Ray spectroscopy, EDX) untersucht, um die Menge von Silberrückständen zu quantifizieren. Die EDX-Analyse erfolgte mit einem Octance Plus-Detektor (EDAX Inc., Mahwah, New Jersey, USA) und der entsprechenden EDAX APEX-Software.

Die Vorbestimmung der Messbereiche ermöglicht es, Korrelationen zwischen der Mikrostruktur des Substrats und der Silberhaftung herzustellen. Eine höhere Menge an Silberrückständen an den einzelnen Kupferkörnern deutet dabei auf eine erhöhte Haftstärke des gesinterten Silbers an dem jeweiligen Korn hin.

### Beispiele:

Die vorliegende Erfindung wird nachstehend durch Ausführungsbeispiele näher beschrieben, die jedoch nicht als einschränkend verstanden werden sollen.

Für die Beispiele wurden Kupfer-Keramik-Substrate mit einer Abmessung von 27 x 38 mm hergestellt, die sich in der Kornorientierung der Kupferschicht unterschieden. Der Keramikkörper bestand aus einer Siliziumnitridkeramik, die Dicke der Kupferschicht betrug 0,3 mm. Es wurden 4 unterschiedliche Kupferfolien mit je einer Reinheit von 99,99 Gew.-% eingesetzt, die sich in ihrer Kornorientierung unterschieden.

Die Einstellung der Kornorientierung der Kupferschicht erfolgte über die Verwendung einer entsprechenden Kupferfolie bei der Herstellung der Kupfer-Keramik-Substrate. Die Einstellung in den verwendeten Kupferfolien erfolgte über die Walz- und Temperaturbehandlungsschritte bei der Herstellung.

### Beispiel 1 (EB1):

Für das Beispiel wurde der Keramikkörper mit einer Kupferfolie mit einer Dicke von 0,3 mm über ein AMB (Active Metal Brazing)-Verfahren verbunden.

### Beispiel 2 (EB2):

Für das Beispiel wurde der Keramikkörper mit einer Kupferfolie über ein DCB (Direct Copper Bonding) -Verfahren verbunden.

### Vergleichsbeispiel 1 (VB1):

Vergleichsbeispiel 1 wurde analog zu Beispiel 1 durchgeführt.

### Vergleichsbeispiel 2 (VB2):

Vergleichsbeispiel 1 wurde analog zu Beispiel 2 durchgeführt.

Die Oberseite der Kupferschicht der Kupfer-Keramik-Substrate wurde mittels EBSD gemäß dem vorstehend beschriebenen Verfahren analysiert. Anschließend wurde das Substrat mit Siliziumchips bestückt, deren Widerstandsfähigkeit gegen ein Abscheren (Schwerfestigkeit) und die Menge an Silberrückständen bestimmt. Die zurückbleibende Silbermenge erlaubt einen Rückschluss auf die Haftfestigkeit der gesinterten Silberschicht.

Die Ergebnisse sind in Tabelle 1 dargestellt.

**Tabelle 1: Ergebnisse der EBSD-Charakterisierung, Scherfestigkeit und Haftfestigkeit der Silbersinterschicht.**

| | Anteil <101> [%] | Anteil <100> [%] | Scherfestigkeit | Haftfestigkeit Ag-Schicht |
|---|---|---|---|---|
| EB1 | 44,4 | 0,6 | ++ | ++ |
| EB2 | 30,8 | 1,0 | ++ | ++ |
| VB1 | 15,5 | 0,4 | + | - |
| VB2 | 10,8 | 0,8 | + | - |

Die Ergebnisse zeigen, dass die erfindungsgemäßen Kupfer-Keramik-Substrate den Kupfer-Keramik-Substraten der Vergleichsbeispiele 1 und 2 in Bezug auf die Scherfestigkeit und die Haftfestigkeit der Sinterschicht überlegen sind. Sie sind somit besser dafür geeignet, unter zur Hilfenahme eines Sintermaterials eine feste Verbindung zu einem Elektronikbauteil zu schaffen.

## Patentansprüche

1. Kupfer-Keramik-Substrat umfassend
a) einen Keramikkörper und
b) eine Kupferschicht, die mit dem Keramikkörper flächig verbunden ist, wobei die Kupferschicht eine Oberseite aufweist die Kupferkörner umfasst,
**dadurch gekennzeichnet, dass**
wenigstens 20 % der Kupferkörner eine <101>-Orientierung in Normalrichtung aufweisen, wobei die Orientierung der Kupferkörner in einer Aufnahme der Oberseite der Kupferschicht mittels Elektronenrückstreubeugung (Electron Backscatter Diffraction, EBSD) bestimmt wird.

2. Kupfer-Keramik-Substrat gemäß Anspruch 1, **dadurch gekennzeichnet, dass** die Oberseite der Kupferschicht einen Anteil der <101>- Kristallorientierung im Bereich von 20 - 90 % aufweist.

3. Kupfer-Keramik-Substrat gemäß einem der vorangegangen Ansprüche, **dadurch gekennzeichnet, dass** die Oberseite der Kupferschicht einen Anteil der <100>-Kristallorientierung der Kupferkörner von wenigstens 0,5 % aufweist.

4. Kupfer-Keramik-Substrat gemäß einem der vorangegangen Ansprüche, **dadurch gekennzeichnet, dass** die Summe der <101>-Kristallorientierung und der <100>-Kristallorientierung der Kupferkörner mindestens 20,5 % beträgt.

5. Kupfer-Keramik-Substrat gemäß einem der vorangegangen Ansprüche, **dadurch gekennzeichnet, dass** die Oberseite der Kupferschicht einen Anteil der <111>-Kristallorientierung der Kupferkörner von weniger als 10 % aufweist.

6. Kupfer-Keramik-Substrat gemäß einem der vorangegangenen Ansprüche, **dadurch gekennzeichnet, dass** die Keramik des Keramikkörpers aus der Gruppe ausgewählt ist, die aus Aluminiumnitridkeramiken, Siliziumnitridkeramiken und Aluminiumoxidkeramiken besteht.

7. Verwendung eines Kupfer-Keramik-Substrats gemäß einem der Ansprüche 1 - 6 zum Verbinden mit einem Elektronikbauteil.

8. Verfahren zur Herstellung einer Verbindung zwischen einem Kupfer-Keramik-Substrat und einem Elektronikbauteil, bei dem man:
a) ein Kupfer-Keramik-Substrat gemäß Anspruch 1 bereitstellt,
b) ein Elektronikbauteil bereitstellt,
c) ein Sintermaterial bereitstellt,
d) das Elektronikbauteil, das Kupfer-Keramik-Substrat und das Sintermaterial so positioniert, dass eine Anordnung geschaffen wird, bei der das Elektronikbauteil mit der Oberseite der Kupferschicht des Kupfer-Keramik-Substrats über das Sintermaterial in Kontakt steht, und
e) die Anordnung einer Behandlung unterzieht, bei der eine Sinterverbindung zwischen dem Elektronikbauteil und dem Kupfer-Keramik-Substrat entsteht.
